# EUROPEAN PATENT APPLICATION

(11) **EP 3 016 128 A1**
(43) Date of publication of application: **04.05.2016**
(21) Application number: 14191074.5
(22) Date of filing: 30.10.2014
(51) Int. Cl.: H01H 85/36, H01H 85/40, H05K 5/06, H01H 85/00

(54) **Subsea fuse assembly**

(71) Applicant: Siemens Aktiengesellschaft, 80333 München (DE)
(72) Inventor: Aarskog, Fredrik Gundersen, 7031 Trondheim (NO)

(57) **Abstract**

A subsea fuse assembly adapted to be operated in a pressurized environment is provided. The subsea fuse assembly has an enclosure having a first part which is hollow and a second part which is a rigid supporting wall. The first part of the enclosure is mounted and sealed to the rigid supporting wall such that the first part of the enclosure and the rigid supporting wall enclose a chamber that is sealed in a liquid-tight manner to the surrounding pressurized environment. A fuse element is arranged inside the chamber. A first electrical terminal and a second electrical terminal are arranged in the rigid supporting wall for leading an electrical connection through the supporting wall for electrically contacting the fuse element. The first part of the enclosure comprises at least a flexible portion configured to allow the first part of the enclosure to expand and contract so as to change the volume of the chamber.

## Description

### Field of the invention

The present invention relates to a subsea fuse assembly for a high pressure environment and to a method of providing such subsea fuse assembly.

### Background

Traditionally, oil platforms are used in the offshore oil and gas production. In the operation of offshore oil platforms, it can be necessary to install electrical equipment under water, e.g. for controlling functions of a subsea Christmas tree or a subsea blowout preventer. More recently, processing facilities are being relocated to the ocean floor. Installations on the ocean floor can comprise a range of components, including pumps, compressors and the like which require electric power for operation. Power supply can occur through a subsea power grid installed on the ocean floor, which may for example comprise a subsea transformer, a subsea switchgear and subsea variable speed drives for powering the above mentioned subsea loads. It needs to be ensured that the installed equipment operates reliably even under the high pressure that prevails at the rated installation depth which can be 3.000 m or more.

To protect the equipment from the corrosive environment of the surrounding seawater and to deal with the high pressures, pressure compensated enclosures can be used which provide pressure balancing between the ambient seawater pressure and the interior of the enclosure. Such pressure compensated enclosure is generally filled with a dielectric liquid which is essentially incompressible and which further provides heat conduction. In such types of enclosures, the electric components provided therein are exposed to the ambient pressure, i.e. the pressure of the high pressure environment prevailing at the subsea installation site.

In such configurations, impurities in the dielectric liquid may become a challenge. In particular, particles in the dielectric liquid may follow the fluid stream and may deposit at places with high electric field strength. Such particles may generate an electric breakdown. If there is a fault in an electric or electronic component within the enclosure, the dielectric liquid may become polluted, and the pollution may affect other components of the subsea equipment.

To provide electrical protection for subsea equipment, fuses are known which can be installed in such pressure compensated subsea enclosure. The document EP 2495746 A1 describes for example a fuse assembly which has a fuse element that is disposed in a housing having an opening that is covered by a membrane. The membrane provides pressure balancing and prevents impurities that may be produced by arcing when the fuse element melts from polluting dielectric liquid present in a device in which the fuse assembly is installed. The membrane needs to withstand the pressure increase upon melting of the fuse element and needs to be capable of providing pressure balancing.

In some applications, subsea devices may need to be installed in large water depths, for example in excess of 2,000 m, they may need to be suitable for operation of a depth of at least 3,000 m. Installation in such depth results in significant pressure changes. Furthermore such devices may be subjected to significant temperature changes. Accordingly, it is desirable that any component of a subsea device is capable of dealing with the pressure changes and temperature differences, and with the volume changes associated therewith. Furthermore, when a fuse element melts, the resulting arcing may produce gasses and pollutions, which may result in a significant volume increase and thus pressure increase within a sealed enclosure in which the fuse is disposed. Previously known fuses may need to employ a particularly strong membrane for dealing with such significant volume/pressure changes. This may increase the risk of a failure of such component, and may furthermore limit the capability for volume or pressure compensation.

### Summary

Accordingly, there is a need for an improved subsea fuse assembly, and in particular for a subsea fuse assembly that is capable of compensating large volume differences while having a relatively simple and reliable configuration.

This need is met by the features of the independent claims. The dependent claims describe embodiments of the invention.

According to an embodiment of the invention, a subsea fuse assembly adapted to be operated in a pressurized environment is provided. The subsea fuse assembly comprises an enclosure having a first part which is hollow and a second part which is a rigid supporting wall. The first part of the enclosure is mounted and sealed to the second part, i.e. to the rigid supporting wall. The mounting is such that the first part of the enclosure and the rigid supporting wall enclose a chamber that is sealed in a liquid-tight manner to the surrounding pressurized environment. Inside the chamber, a fuse element is arranged. The subsea fuse assembly has a first electrical terminal and a second electrical terminal arranged in the rigid supporting wall for leading an electrical connection through the supporting wall for electrically contacting the fuse element. The first part of the enclosure comprises at least a flexible portion configured to allow the first part of the enclosure to expand and contract so as to change the volume of the chamber and to enable a pressure balancing between a pressure prevailing inside the chamber and a pressure prevailing in the pressurized environment. The flexible portion is configured such that a wall portion of the first part of the enclosure, which wall portion is located opposite of the rigid supporting wall, is movable so as to change the distance between the rigid supporting wall and the wall portion.

By having a flexible portion of the first part of the enclosure that allows a wall portion to change its distance to the rigid supporting wall, the volume compensation capability of the enclosure can be increased significantly. As an example, if the fuse element melts and due to the resulting arcing, gasses develop within the enclosure, the wall portion can move away from the rigid supporting wall so as to accommodate the additional volume of the produced gasses. By providing the first and second electrical terminals in the rigid supporting wall, the movement of the wall portion of the first part of the enclosure is enabled, since it is not necessary to provide electrical connections therethrough. The flexible portion of the first part of the enclosure may itself provide pressure compensation by increasing or decreasing its outer perimeter, and furthermore deforms so as to allow the wall portion of the first part to change its distance to the rigid supporting wall. Effective pressure compensation and the compensation of significant volume changes due to the melting of a fuse element thus become possible. Since the first part of the enclosure and the rigid supporting wall provide a liquid-tight sealing to the surrounding environment, contamination, debris and the like which may form upon the melting of the fuse element cannot leave the chamber, thus preventing pollution of the environment surrounding the enclosure.

In an embodiment, the first part of the enclosure comprises a side wall section, in particular a cylindrical section. The side wall section is arranged between the wall portion and the rigid supporting wall. The flexible portion forms part of the side wall section. The flexible portion may thus allow the side wall section to extend and contract, thereby increasing or decreasing the distance between the wall portion and the rigid supporting wall. The side wall section, in particular the flexible section, may be arranged to provide a barrier between the chamber, i.e. inside the enclosure, and the surrounding pressurized environment.

The flexible portion of the first part of the enclosure may comprise or may consist of a bellows portion. Such bellows portion allows the first part of the enclosure to expand and contract by a significant amount, and may thus allow the wall portion to change its distance to the rigid supporting wall by a significant amount. Large volume changes of a medium filling the enclosure may thus be compensated by the enclosure.

The wall portion of the first part of the enclosure may be formed by a rigid cover, in particular by a disk-shaped or rectangular rigid cover. Such rigid cover might provide protection for the components disposed inside the chamber.

The first part of the enclosure may comprise or consist of a cylindrical section having two openings. The flexible portion may be a bellows portion forming part of the cylindrical section. The wall portion may be provided by means of a rigid cover which is mounted and sealed to one opening of the cylindrical section. The rigid supporting wall may be mounted and sealed to the other opening of the cylindrical section. Mounting and sealing may for example occur by means of a flange and bolts, an O-ring seal and/or a metal-to-metal seal, for example by a resilient O-ring seal or a metal O-ring seal. Yet it may also occur by means of soldering or welding or molding, depending on the type of material used for the different components of the enclosure.

In an embodiment, the first part of the enclosure has a side wall section and a cover, the side wall section being located between the cover and the rigid supporting wall. At least part of the side wall section or the whole side wall section may be made of a resilient material to provide the flexible portion. Some rubber or plastic material, in particular polymer material may be used to provide the flexible portion. As an example, a membrane which can be stretched may be used to provide the flexible portion. In other embodiments, the first part of the enclosure may be completely made of a resilient material.

In a further embodiment, the flexible portion of the first part of the enclosure may be a telescopic portion, which may allow the expansion and contraction of the first part of the enclosure by two or more telescopic elements which may be sealed against each other and which are allowed to slide against each other. In such configuration, the enclosure can be made relatively compact and robust, while at the same time allowing for relatively large volume changes of its interior chamber.

In an embodiment, the fuse element has a first fuse terminal and a second fuse terminal. The first fuse terminal is electrically and mechanically connected to the first electrical terminal provided in the rigid supporting wall. The subsea fuse assembly may further comprise a mechanical linkage element which provides a mechanical linkage between the second fuse terminal and the wall portion of the first part of the enclosure. By such configuration, it may be achieved that upon the melting of the fuse element and the resulting increase in volume due to the production of gasses, the enclosure compensates the volume increase by movement of the wall portion away from the rigid supporting wall, whereby, due to the mechanical linkage element, the second fuse terminal may be spatially separated from the first fuse terminal. In such configuration, the extinguishing of an arc forming upon the melting of the fuse element may be accelerated. Arc duration may thus be reduced, and the amount of contamination including debris and gasses that is produced upon melting of the fuse element may be reduced.

The mechanical linkage element may be configured such that at least when the wall portion is moved to increase the distance to the rigid supporting wall by a predetermined distance, a separating force is applied to the second fuse terminal which acts to increase the spatial separation between the second fuse terminal and the first fuse terminal. Accordingly, during normal operation, when the enclosure provides pressure compensation by means of its flexible portion, no stress may be applied to a fuse element by the mechanical linkage element. After the fuse element melts, thus leading to an increased volume inside the enclosure and to a separation of the wall portion from the rigid supporting wall by more than the predetermined distance, the second fuse terminal is pulled away by means of the mechanical linkage element from the first fuse terminal, thus increasing separation and accelerating arc extinction. The mechanical linkage may for example be a chain, a wire, a line or a spring having slack. The slack may be adjusted such that the mechanical linkage element applies a force to the second fuse terminal only after the wall portion has increased its distance to the rigid supporting wall by said predetermined distance. In other embodiments, the mechanical linkage element may for example be a spring which may increase the applied force constantly with the separation between the wall portion and the rigid supporting wall, or which may increase the applied spring force only after a certain elongation of the spring.

The mechanical linkage element may comprise a flexible element having slack or being bent. Besides a chain, a wire, or a rope, such flexible element may also be provided by a metal strip or plastic strip or the like. If it is implemented as a spring, it may for example comprise a coil spring or a leaf spring.

In an embodiment, the fuse element is a first fuse element, and the subsea fuse assembly comprises at least a further second fuse element. The first fuse element and the second fuse element are connected in series between the first and second electrical terminals. By using at least two fuse elements in series, it may become possible to break higher voltages.

The first and second fuse elements may be arranged to extend (along their longitudinal direction) between the supporting wall and the wall portion. One end of the first fuse element is connected to the first electrical terminal and one end of the second fuse element is connected to the second electrical terminal. The other ends of the first and second fuse elements (which may be termed second fuse terminals) are each connected to an electrical conductor for providing the series connection. In particular, the longitudinal extension of the first and second fuse elements may be substantially perpendicular to the rigid supporting wall. The electrical conductor may for example be a conductive bar, in particular a metal bar, such as a copper bar or a steel bar. Other configurations are certainly conceivable. As an example, a third fuse element may be connected between the second fuse terminals of the first and second fuse elements, thus achieving a series connection of three fuse elements.

The electrical conductor may extend substantially parallel to the rigid supporting wall. The electrical conductor may be a rigid conductor, in particular a conductive bar. A mechanical linkage element (such as the one mentioned further above) may be mechanically coupled to the rigid conductor and to the wall portion. Accordingly, when the wall portion increases its distance to the rigid supporting wall, the mechanical linkage may be configured to apply a force to the second fuse terminals of both the first and the second fuse elements, thus increasing the distance between the two fuse terminals of each fuse element, and accelerating the extinguishing of an arc. The mechanical linkage element may for example be coupled to a central portion of the rigid conductor, or the mechanical linkage element may comprise two elements each coupled to a portion close to an end of the rigid conductor, such as two springs, two chains, two wires or the like. A relatively symmetric application of force to both fuse elements may thus be achieved.

The subsea fuse assembly may further comprise a separating wall arranged between the first and the second fuse elements. Such separating wall may provide mechanical stability. The separating wall may be made of an electrically insulating material, such as a plastic material or the like. The separating wall may thus prevent an arcing between the two fuse elements.

In particular, the separating wall may provide mechanical support for the electrical conductor. The electrical conductor may rest on the separating wall in such way that when a force is applied to the electrical conductor by the mechanical linkage element, the electrical conductor can move away from the separating wall in order to provide the separating force to the second fuse terminals.

The first electrical terminal and the second electrical terminal may each be provided by a penetrator through the rigid supporting wall. Such penetrator may for example comprise a conductive core and an electrically insulating sleeve. Preferably, each penetrator comprises a ceramic insulating sleeve. As an example, the electrical conductors forming the terminals may be cast in a ceramic material.

The rigid supporting wall may be made of a metal, in particular of steel or may be made of a rigid plastic material. The flexible portion of the first part of the enclosure may also be made of a metal, it may for example be provided by a metal bellows. Rigid means that the material is stiff enough to support the first and second electrical terminals and the first part of the enclosure.

The enclosure may furthermore comprise a filling port which is sealable for filling the enclosure with a dielectric liquid and/or sand. The filling port may for example be provided in a side wall section or in a cover of the first part of the enclosure.

The chamber provided inside the enclosure may be filled with a dielectric liquid, or with a mixture of dielectric liquid and sand. Liquid is substantially incompressible, so that the volume changes that need to be compensated upon an increase of the pressure in the pressurized environment, for example when the subsea fuse assembly is installed at a subsea location, are relatively small and can thus be easily compensated. Furthermore, by providing a mixture of dielectric liquid and sand inside the chamber, the extinguishing of an arc which forms between the fuse terminals of the fuse element upon melting of the fuse element can be accelerated.

In an embodiment, at least a portion of the enclosure may be configured to break when a pressure inside the chamber exceeds a pressure of an ambient medium outside the enclosure by a predetermined pressure difference. Such configuration may be provided in order to provide a leakage path for a medium that is present in the chamber, for example the dielectric liquid or for gases which might have formed. Accordingly, if an overpressure builds up inside the enclosure, the pressure can be released by means of this leakage path. If a device in which the subsea fuse assembly is for example retrieved from a subsea location, the safety of service personal working with or near the subsea fuse assembly after retrieval can be improved by providing such breaking of the enclosure. The enclosure may for example be configured to break when the pressure difference between the chamber and the surrounding environment exceeds a pressure within the range of between about 0.5 and about 3 bar, for example if the pressure difference exceeds 1 bar.

Due to the configuration of the enclosure which allows a relatively large expansion and contraction and thus changes of the volume of the interior chamber, the housing may be made relatively weak since in normal operation, even if a fuse element melts, the buildup of a significant pressure difference can be avoided.

A further embodiment of the invention relates to a method of providing a subsea fuse assembly for a pressurized environment. The method comprises the steps of providing an enclosure having a first part which is hollow and a second part which is a rigid supporting wall, the enclosure enclosing a chamber; arranging a fuse element inside the chamber; mounting and sealing the first part of the enclosure to the rigid supporting wall such that the first part of the enclosure and the rigid supporting wall provide a liquid-tight sealing of the chamber to the surrounding environment; and providing a first electrical terminal and a second electrical terminal in the rigid supporting wall for leading an electrical connection through the supporting wall for electrically contacting the fuse element. The first part of the enclosure comprises at least a flexible portion configured to allow the first part of the enclosure to expand and contract so as to change the volume of the chamber and to enable a pressure balancing of the pressure inside the chamber to the pressurized environment. The flexible portion is configured such that a wall portion of the first part of the enclosure that is located opposite of the rigid supporting wall is movable so as to change the distance between the rigid supporting wall and the wall portion.

By such method, advantages similar to the ones outlines further above with respect to the subsea fuse assembly may be achieved. The method may be performed so as to provide a subsea fuse assembly in any of the above outlined configurations. In particular, method steps described above with respect to the subsea fuse assembly may form part of embodiments of the method.

It is to be understood that the features mentioned above and those yet to be explained below can be used not only in the respective combinations indicated, but also in other combinations or in isolation, without leaving the scope of the present invention.

### Brief description of the drawings

The foregoing and other features and advantages of the invention will become further apparent from the following detailed description read in conjunction with the accompanying drawings. In the drawings, like reference numerals refer to like elements.
Figure 1 is a schematic drawing showing a sectional side view of a subsea fuse assembly according to an embodiment.
Figure 2 is a schematic drawing showing a sectional side view of a subsea fuse assembly according to a further embodiment.
Figures 3A to 3C are schematic drawings showing sectional side views of a subsea fuse assembly according to an embodiment, the drawings illustrating a time series showing the different stages upon melting of a fuse element.

### Detailed description

In the following, embodiments of the invention will be described in detail with reference to the accompanying drawings. It is to be understood that the following description of the embodiments is given only for the purpose of illustration and is not to be taken in a limiting sense. It should be noted that the drawings are to be regarded as being schematic representations only, and elements in the drawings are not necessarily to scale with each other. Rather, the representation of the various elements is chosen such that their function and general purpose become apparent to a person skilled in the art.

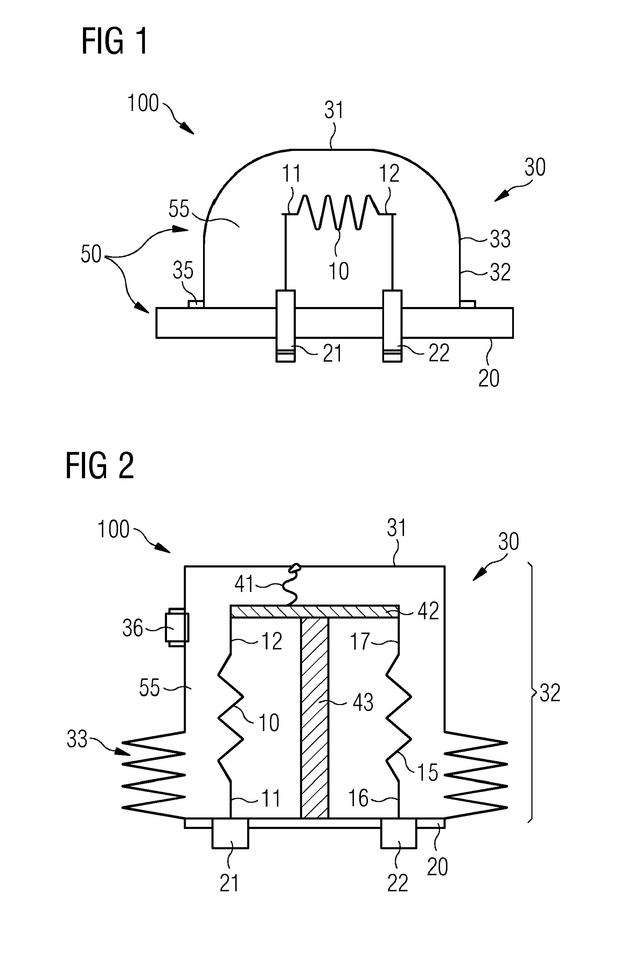

Figure 1 shows a subsea fuse assembly 100 having a rigid supporting wall 20 in which the first and second electrical terminals 21, 22 are arranged. Rigid in this sense means that the supporting wall 20 is strong enough to carry the electrical terminals 21, 22 to which for example a cable or bus bar is attached, which conduct the current that is to be broken by the fuse assembly. The enclosure 50 of the subsea fuse assembly 100 has a first part 30 which is hollow. Together with a second part of the enclosure 50 formed by the rigid supporting wall 20, a chamber 55 is enclosed. In chamber 55, a fuse element 10 is disposed. Fuse element 10 is electrically contacted via the first and second electrical terminals 21, 22. As illustrated, a first fuse terminal 11 is electrically connected to the first electrical terminal 21 and a second fuse terminal 12 is electrically connected to the second electrical terminal 22. If a current flowing through fuse element 10 exceeds a predetermined threshold current, the fuse element 10 melts and thus interrupts the current. Fuse element 10 can be configured in different ways. Fuse element 10 may for example be a metal strip, a perforated metal strip, coiled metal, or the like. Any suitable fuse element may be employed, depending on the particular application.

The first part 30 of the enclosure 50 has a wall portion 31 that is located opposite of the rigid supporting wall 20. Furthermore, it includes a flexible portion 33. The flexible portion 33 preferably constitutes a portion of the side wall section 32 of the first part 30. As an example, the side wall section 32 may comprise a circumferential section of flexible material, such as rubber, a polymer material or the like, or may comprise a bellows portion or a telescopic portion. The flexible portion 33 is configured such that if the volume of a medium filling chamber 55 increases, for example due to a temperature change, due to the generation of gasses inside chamber 55, or due to a decreasing pressure outside the enclosure 50, such volume change is accommodated by a deformation of the flexible portion 33. In particular, it is configured such that upon an increase of the volume of the medium, the wall portion 31 is enabled to increase its distance to the supporting wall 20, and when the volume of the medium filling chamber 55 is reduced, wall portion 31 is allowed to decrease its distance to supporting wall 20. As can be seen from figure 1, already a small expansion of the flexible portion 33 perpendicular to the supporting wall 20 and the resulting increase in distance between supporting wall 20 and wall portion 31 results in a significant increase of the volume of chamber 55. Accordingly, with the configuration illustrated in figure 1, significant volume changes of a medium filling chamber 55 can be compensated.

The flexible portion 33 also provides pressure compensation by expanding, bending and/or flexing, for example an inwards or outwards bulging of the respective side wall section 32. Due to the flexibility of portion 33, the outside pressure in the surrounding environment is transmitted to inside the chamber 55. The pressure in chamber 55 is thus substantially equal to the pressure in the surrounding environment, wherein a small pressure difference may be present, since a certain spring constant may be associated with the flexible portion 33 of the enclosure 50, which acts against an expansion.

In other embodiments, both the side wall section 32 and the wall portion 31 may constitute the flexible portion, they may for example be made of a resilient material, in particular of a rubber material. Accordingly, the first part 30 including the side wall section 32 and the wall portion 31 may expand and contract in a bladder-like manner. Again, such configuration allows significant changes of the volume of chamber 55.

The first part 30 of enclosure 50 is mounted and sealed to the second part constituted by supporting wall 20, which has the shape of a circular or rectangular supporting plate. By means of such sealing, pollution that may be produced inside the chamber 55 is prevented from contaminating the environment surrounding subsea fuse assembly 100. Subsea fuse assembly 100 may for example be disposed inside a subsea enclosure of an electric device, in which further electric and/or electronic components may be disposed that can be sensitive to such contamination. Both, the subsea enclosure of such device, as well as the chamber 55 are preferably filled with a dielectric liquid. When the fuse element 10 melts, i.e. the fuse "blows", the resulting arcing can generate both gasses inside the dielectric liquid, and can furthermore generate particles which contaminate and pollute the dielectric liquid. These are effectively confined within the chamber 55. The generation of gasses will lead to an increase of the volume of the medium inside chamber 55 and an increase in pressure. By the expansion of the first part 30 of enclosure 50, the additional volume is accommodated and consequently, the pressure is brought back to a level corresponding to that of the pressure in the surrounding environment.

There are several possibilities of mounting and sealing the first part 30 to the supporting plate 20. Possibilities include bolting, clamping, welding, soldering, molding and the like, depending on the type of material employed. As an example, a flange 33 may be used to bolt the first part 30 to the supporting wall 20. On such flange, seals, such as a resilient O-ring seal or a metal O-ring seal may be provided. If both, the first part 30 and the supporting wall 20 are made of a plastic material, they may be molded together. If both, the first and the second part of enclosure 50 are made of metal, they may be soldered or welded together to provide both mounting and sealing.

Figure 2 illustrates a particular embodiment of the general embodiment of figure 1. Accordingly, the explanations given above are equally applicable to figure 2. In figure 2, a first part 30 of enclosure 50 includes a flexible portion 33 in form of a bellows portion, which forms part of the side wall section 32. Within chamber 55, a first fuse element 10 and a second fuse element 15 are arranged. Fuse elements 10, 15 are series-connected between the first and second electrical terminals 21, 22. The first fuse terminal 11, 16 of each fuse element 10, 15 is connected to the electrical terminal 21, 22, respectively, and a second fuse terminal 12, 17 of each fuse element 10, 15 is connected to a conductor 42, in particular a metal bar, for example a copper or steel bar. Thus, a series connection between the two electrical terminals 21, 22 is achieved. By means of the mechanical linkage element 41, the second fuse terminal 12 of fuse element 10 is mechanically coupled to the wall portion 31 of the first part 30 of the enclosure. As indicated by the shape of the mechanical linkage element 41, a certain slack is provided so that the wall portion 31 is allowed to travel a certain distance before applying a force to the conductor 42 and thus to the second fuse terminal 12. The mechanical linkage element 41 can for example be implemented in form of a chain, a wire, a rope, a metal strip, a plastic strip, a coil spring, a leave spring or the like. It may comprise one, two or more of such elements.

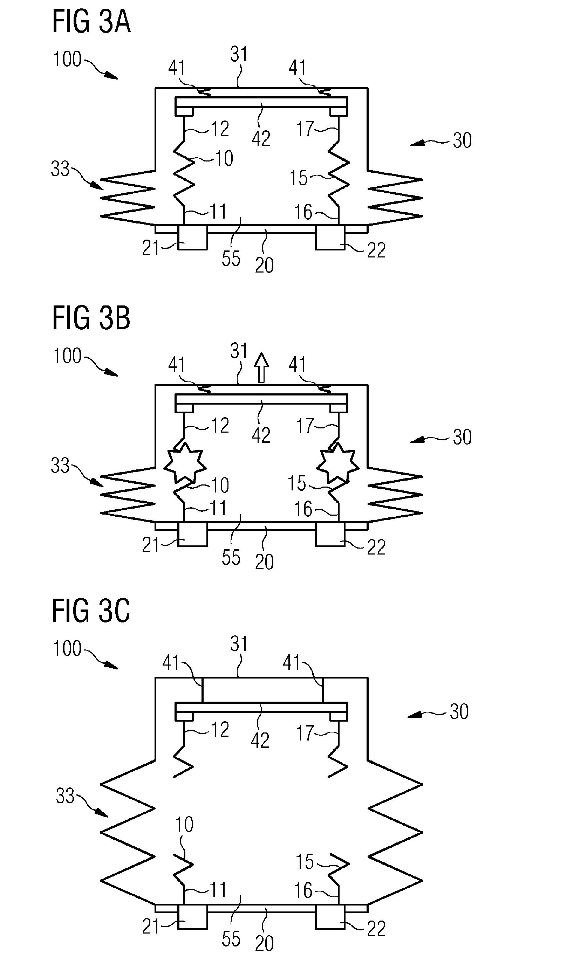

As can be seen, the second fuse terminal 12 is mechanically connected to the mechanical linkage element 41 via the electrical conductor 42. In other embodiments, it may be directly coupled to the mechanical linkage element 41. Since both second fuse terminals 12, 17 are electrically connected and mechanically coupled to the conductor 42, they are both linked via the mechanical linkage element to the wall portion 31. Accordingly, if wall portion 31 moves away from the rigid supporting wall 20, linkage element 41 applies after a certain travel distance a force to the electrical conductor 42, which in turn applies a separating force to the second fuse terminals 12, 17 in a direction away from the first fuse terminals 11, 16. Such configuration supports the extinguishing of an arc forming between the first and second fuse terminals, as will be explained in more detail further below with respect to figure 3.

In chamber 55, a separating wall 43 is furthermore arranged. As can be seen, both the first and second fuse elements 10, 15 and the separating wall 43 extend in a direction which is substantially perpendicular to the supporting wall 20, away from the supporting wall 20. The separating wall 43 is arranged between the first and second fuse elements 10, 15. The separating wall 43 may be made of an insulating material, such as a plastic insulator or ceramic insulator. Accordingly, separating wall 43 may prevent arcing from occurring between the first and second fuse elements 10, 15.

Separating wall 43 is furthermore configured to provide mechanical support for the electrical conductor 42. Electrical conductor 42 rests on supporting wall 43. A connecting structure may be provided between the electrical conductor 42 and the separating wall 43 to prevent a misalignment, for example a protrusion in one element and a recess in the other. Electrical conductor 42 is not fixed to the separating wall 43, but is allowed to separate and move away from separating wall 43 upon application of force to the electrical conductor 42 by the mechanical linkage element 41.

A filling port 36 is provided in the enclosure 50, in particular in the first part 30 of the enclosure in the example of figure 2. Filling port 36 can be used for filling chamber 55 with a dielectric liquid, and in particular with a mixture of dielectric liquid and sand. When the fuse elements melt and arcing occurs in each fuse element, sand surrounding each arc may absorb energy and may thus support the quenching of the arc. As an example, sand may first be filled into the chamber 55, the chamber 55 may then be evacuated and the dielectric liquid may be filled into chamber 55, thus avoiding the formation of air pockets.

Figure 3 illustrates a further embodiment of the subsea fuse assembly and shows a time series which may occur when the fuse "blows". The embodiment of the subsea fuse assembly essentially corresponds to that illustrated in figure 2, so that the above explanations are equally applicable. In particular, the subsea fuse assembly 100 of figure 3 comprises a mechanical linkage element 41 in form of two flexible strings or chains. The filling port 36 is not illustrated in figure 3. By a mechanical linkage element having two flexible elements, the force applied by movement of the wall portion 31 may be distributed more evenly to the second fuse terminals 12, 17 of the two fuse elements 10, 15.

Figure 3 illustrates the situation in which the subsea fuse assembly 100 is in normal operation, with the mechanical linkage element 41 being in a relaxed state. In this state of operation, the flexible portion 33 of the enclosure provides pressure compensation, for example if the temperature of the medium filling chamber 55 or if the temperature of the outside environment changes.

Figure 3B illustrates the occurrence of an over current situation where the fuse elements need to break the current. As indicated by the stars, the excessive current will cause heating of the fuse elements and the fuse elements 10, 15 melt. In consequence, arcing will occur in each fuse element. During arcing, gases and debris develop, which will cause an expansion and increase in the volume of the medium filling the chamber 55. The enclosure 50 confines the generated gases and debris to within the chamber 55. The increase in volume is accommodated by movement of wall portion 31 away from the supporting wall 20, as indicated by the arrow. As a result of such movement, the mechanical linkage elements 41 are being stretched and start to apply a force to the electrical conductor 42, which in turn applies a respective force to the second fuse terminals 12, 17.

Since the fuse elements 10, 15 are melted, the second fuse terminals 12, 17 move together with conductor 42 and wall portion 31 away from the supporting wall 20, thus increasing the spatial separation between the first fuse terminals 11, 16 and the second fuse terminals 12, 17. This situation is illustrated in figure 3C. The flexible portion 33 in forms of the bellows portion is now expanded, and the mechanical linkage element 41 is similarly in an expanded state. As can be seen, the separation between the first fuse terminals 11, 16 and the second fuse terminals 12, 17 has increased. This increases the length of each arc, which accelerates the extinction of the arc and thus the breaking of the current.

It should be clear that the features of the embodiments described above can be combined with each other unless noted to the contrary.

By embodiments of the subsea fuse assembly 100, several advantages can be achieved. During pressurization of the environment surrounding the subsea fuse assembly, for example when the subsea fuse assembly is disposed in a pressure compensated subsea enclosure and is being installed at a subsea location, the flexibility of the enclosure 50 will act as a pressure compensator, accommodating volume changes of the medium filling chamber 55 due to pressure changes and temperature changes. In particular, it will ensure that the pressure inside chamber 55 is substantially equal to the external pressure prevailing in the surrounding pressurized environment. This will prevent an implosion of the enclosure 50, and allows the use of relatively thin walls for the enclosure 50, compared to solutions which make use of an atmospheric canister for housing a fuse. The enclosure 50 further enables the fuse assembly to contain pollution, gasses or debris that may be created during the melting of a fuse element. Pollution of a surrounding dielectric liquid and thus damage of nearby electric or electronic components can thus be prevented. As a further benefit, such solution is also more cost-efficient to produce compared to an atmospheric canister type fuse.

Since a relatively thin walled enclosure may be used for the subsea fuse assembly, it can be configured to break at a relatively low pressure difference between the interior of the enclosure 50 and the outside environment. As an example, the enclosure may break if the pressure inside the enclosure is one bar higher than the pressure in the surrounding environment. When the subsea fuse assembly is retrieved from the subsea location, and gases have formed inside the chamber 55, these gases expand upon a decrease of the surrounding pressure (during retrieval of the subsea device), and they may expand to a degree where the enclosure is no longer capable of accommodating the volume change, thus leading to an increase of the internal pressure compared to the environment. When the enclosure breaks, it will release the expanding gases when being depressurized. This way, the safety of service personal working on or near the subsea fuse assembly after depressurization can be ensured. If the housing would be configured to contain the pressurized gasses, these may be dangerous to service personal when attempting to open the enclosure.

In a particular embodiment, the flexible portion of the first part of the enclosure may be configured such that a compression and expansion of the first part of the enclosure is only allowed to occur in direction that is substantially perpendicular to the supporting wall (i.e. the up/down direction in the drawings).

Embodiments of the subsea fuse assembly are furthermore configured in such way that a separating force is applied to the fuse elements if a pressure buildup occurs inside the enclosure due to the melting of the fuse element. Thus, the current breaking properties of the subsea fuse assembly can be improved.

While specific embodiments are disclosed herein, various changes and modifications can be made without departing from the scope of the invention. The present embodiments are to be considered in all respects as illustrative and non-restrictive, and all changes coming within the meaning and equivalency range of the appended claims are intended to be embraced therein.

## Claims

1. A subsea fuse assembly adapted to be operated in a pressurized environment, comprising:
- an enclosure (50) having a first part (30) which is hollow and a second part which is a rigid supporting wall (20), the first part (30) of the enclosure being mounted and sealed to the rigid supporting wall (20) such that the first part of the enclosure and the rigid supporting wall enclose a chamber (55) that is sealed in a liquid tight manner to the surrounding pressurized environment,
- a fuse element (10, 15) arranged inside the chamber (55),
- a first electrical terminal (21) and a second electrical terminal (22) arranged in the rigid supporting wall (20) for leading an electrical connection through the rigid supporting wall for electrically contacting the fuse element,
wherein the first part (30) of the enclosure comprises at least a flexible portion (33) configured to allow the first part of the enclosure to expand and contract so as to change the volume of the chamber (55) and to enable a pressure balancing of the pressure inside the chamber (55) to the pressurized environment,
wherein the flexible portion (33) is configured such that a wall portion (31) of the first part (30) of the enclosure that is located opposite of the rigid supporting wall (20) is movable so as to change the distance between the rigid supporting wall (20) and said wall portion (31).

2. The subsea fuse assembly according to claim 1, wherein the first part (30) of the enclosure comprises a side wall section (32), in particular a cylindrical section, said side wall section (32) being arranged between said wall portion (31) and said rigid supporting wall (20), said flexible portion (33) forming part of the side wall section (32).

3. The subsea fuse assembly according to claim 1 or 2, wherein the flexible portion (33) of the first part of the enclosure comprises or consists of a bellows portion.

4. The subsea fuse assembly according to any of the preceding claims, wherein said wall portion (31) of the first part (30) of the enclosure is a rigid cover, in particular a disc shaped or rectangular rigid cover.

5. The subsea fuse assembly according to claims 2, 3 and 4, wherein the first part (30) of the enclosure comprises or consists of a cylindrical section having two openings, the flexible portion (33) being a bellows portion forming part of the cylindrical section, said wall portion (31) being a rigid cover which is mounted and sealed to one opening of the cylindrical section, wherein said rigid supporting wall (20) is mounted and sealed to the other opening of the cylindrical section.

6. The subsea fuse assembly according to any of the preceding claims, wherein the first part (30) of the enclosure has a side wall section (32) and a cover providing said wall portion (31), the side wall section (32) being located between the cover and the rigid supporting wall (20), wherein at least part of the side wall section or the whole side wall section is made of a resilient material to provide said flexible portion.

7. The subsea fuse assembly according to any of the preceding claims, wherein the fuse element (10, 15) has a first fuse terminal (11, 16) and a second fuse terminal (12, 17), wherein the first fuse terminal (11, 16) is electrically and mechanically connected to the first or second electrical terminal (21, 22) provided in the rigid supporting wall (20), wherein the subsea fuse assembly (100) further comprises a mechanical linkage element (41) which provides a mechanical linkage between the second fuse terminal (12, 17) and said wall portion (31) of the first part (30) of the enclosure.

8. The subsea fuse assembly according to claim 7, wherein the mechanical linkage element (41) is configured such that at least when said wall portion (31) is moved to increase the distance to the rigid supporting wall (20) by a predetermined distance, a separating force is applied to the second fuse terminal (12, 17) which acts to increase the spatial separation between the second fuse terminal (12, 17) and the first fuse terminal (11, 16).

9. The subsea fuse assembly according to claim 7 or 8, wherein mechanical linkage element (41) comprises a flexible element having slack or being bent, in particular a chain, a wire, a rope, a metal strip or a plastic strip, or wherein the mechanical linkage element comprises a spring, in particular a coil spring or a leaf spring.

10. The subsea fuse assembly according to any of the preceding claims, wherein the fuse element (10) is a first fuse element, the subsea fuse assembly comprising at least a further second fuse element (15), the first fuse element (10) and second fuse element (15) being connected in series between the first and second electrical terminals (21, 22).

11. The subsea fuse assembly according to claim 10, wherein the first and second fuse elements (10, 15) are arranged to extend between the rigid supporting wall (20) and said wall portion (31), wherein one end of the first fuse element (10) is connected to the first electrical terminal (21) and one end of the second fuse element (15) is connected to the second electrical terminal (22), and wherein the other ends of the first and second fuse elements (10, 15) are each connected to an electrical conductor (42) for providing the series connection.

12. The subsea fuse assembly according to claim 11, wherein the electrical conductor (42) extends substantially parallel to the rigid supporting wall (20), and wherein the electrical conductor (42) is a rigid conductor, wherein a mechanical linkage element (42) is mechanically coupled to the rigid conductor (42) and to the wall portion (31).

13. The subsea fuse assembly according to any of claims 10 to 12, wherein the subsea fuse assembly further comprises an separating wall (43) arranged between the first and the second fuse elements (10, 15), the separating wall (43) being preferably made of an electrically insulating material, in particular of a plastic or ceramic material.

14. The subsea fuse assembly according to claim 13 and to claim 11 or 12, wherein the separating (43) wall provides a mechanical support for the electrical conductor (42).

15. A method of providing a subsea fuse assembly adapted to be operated in a pressurized environment, the method comprising the steps of
- providing an enclosure (50) having a first part (30) which is hollow and a second part which is a rigid supporting wall (20), the enclosure enclosing a chamber (55),
- arranging a fuse element (10, 15) inside the chamber (55),
- mounting and sealing the first part (30) of the enclosure to the rigid supporting wall (20) such that the first part of the enclosure and the rigid supporting wall provide a liquid-tight sealing of the chamber (55) to the surrounding pressurized environment, and
- providing a first electrical terminal (21) and a second electrical terminal (22) in the rigid supporting wall for leading an electrical connection through the rigid supporting wall (20) for electrically contacting the fuse element (10, 15),
wherein the first part (30) of the enclosure comprises at least a flexible portion (33) configured to allow the first part (30) of the enclosure to expand and contract so as to change the volume of the chamber (55) and to enable a pressure balancing of the pressure inside the chamber to the pressurized environment,
wherein the flexible portion (33) is configured such that a wall portion (31) of the first part (30) of the enclosure that is located opposite of the rigid supporting wall (20) is movable so as to change the distance between the rigid supporting wall (20) and said wall portion (31).
